# EUROPÄISCHE PATENTANMELDUNG

(11) **EP 4 700 413 A1**
(43) Veröffentlichungstag der Anmeldung: **25.02.2026**
(21) Anmeldenummer: 24195573.1
(22) Anmeldetag: 21.08.2024
(51) Int. Cl.: G01R 31/42

(54) **STÜTZUNG EINES DATENBASIERTEN CONDITION MONITORING VERFAHRENS DURCH SIGNATURANALYSE UND AUSWERTUNG ÜBERABGETASTETER MESSGRÖSSEN UND SCHALTZUSTÄNDE**

(71) Anmelder: Siemens Aktiengesellschaft, 80333 München (DE); Karlsruher Institut für Technologie, 76131 Karlsruhe (DE)
(72) Erfinder: Liske, Andreas, 76327 Pfinztal (DE); Tsotoulidis, Savvas, 35132 Lamia (GR); Schmitz-Rode, Benedikt, 76185 Karlsruhe (DE); Krug, Dietmar, 90425 Nürnberg (DE)
(74) Vertreter: Siemens Patent Attorneys

(57) **Zusammenfassung**

Die vorliegende Erfindung betrifft ein Computer-implementiertes Verfahren, eine Computer-implementierte Vorrichtung, ein System sowie ein Computerprogrammprodukt zum Bestimmen eines Degradationsfortschritts eines Stromrichters umfassend Erfassen eines zeitlichen Verlaufs eines Ausgangsstroms und/oder einer Ausgangsspannung des Stromrichters, wobei der Ausgangsstrom und/oder die Ausgangsspannung zur Zuführung zu einem elektrischen Antriebsmittel bestimmt ist, Bestimmen zumindest eines für den Degradationsfortschritt indikativen Parameters basierend auf dem erfassten zeitlichen Verlauf, Vergleichen des zumindest einen Parameters mit einem vorbestimmten, für den Degradationsfortschritt indikativen Parameters sowie Bestimmen des Degradationsfortschritts zumindest teilweise basierend auf dem Vergleichen.

## Beschreibung

Die vorliegende Erfindung betrifft ein Computer-implementiertes Verfahren, eine Computer-implementierte Vorrichtung, ein System sowie ein Computerprogrammprodukt zum Bestimmen eines Degradationsfortschritts eines Umrichters.

Elektrische Bauteile unterliegen im Allgemeinen einem Alterungsprozess. Diese können z.B. durch wiederholtes Erwärmen und Abkühlen der betreffenden Bauteile im Regelbetrieb verursacht werden, durch im Material der elektrischen Bauteile vorhandene Materialdefekte, etc. Dieser Alterungsprozess führt zu einer in der Regel begrenzten Lebenszeit der betreffenden Bauteile, welche folglich nach einer gewissen Einsatzzeit ausgetauscht werden müssen.

Die verbleibende Lebenszeit von Komponenten in einem elektrischen System (z.B. in einem Stromrichtersystem) kann für einen Anlagenbetreiber häufig schwer zu ermitteln sein.

Das Bestimmen einer zu verbleibenden Lebenszeit kann sowohl für einen Hersteller des jeweiligen elektrischen Bauteils als auch für einen Systemadministrator, welcher für eine Implementierung des jeweiligen elektrischen Bauteils zuständig ist, eine Herausforderung darstellen. Hersteller führen diesbezüglich häufig offline Berechnungen durch, um eine zu erwartete Lebenszeit eines Bauteils (z.B. eines Leistungswandlers) zu bestimmen und führen diese dann in ihren Dokumentationen auf. Diese Berechnungen basieren meist auf Lastprofilen und Produktnutzung, wie sie über einen idealen Produktzyklus hinweg auftreten kann, während typische Randbedingungen in Betracht gezogen werden, wie z.B. Temperatur, Feuchtigkeit, Höhe, etc.

Die Ermittlung der verbleibenden Lebenszeit kann z.B. durch eine regelmäßige Wartung der betreffenden Komponenten erfolgen. In einem derartigen Fall können z.B. zwei Wartungsstrategien in Frage kommen. Es ist ggf. möglich, basierend auf den bekannten Lastprofilen und spezifizierten Umgebungsbedingungen Wartungsintervalle festzulegen, zu deren Zeitpunkten die zu wartenden Komponenten mit hoher Wahrscheinlichkeit noch funktionstüchtig sind. Die Wahl dieser Wartungsintervalle kann jedoch häufig dazu führen, dass Komponenten mit ggf. noch beträchtlicher verbliebener Lebenszeit ausgetauscht werden, was zu (unnötig) hohen Kosten und Materialeinsatz führen kann.

Als weitere Wartungsstrategie, falls Stillstandzeiten des elektrischen Systems in Kauf genommen werden können, kann auch ein Austausch der betreffenden Komponente erfolgen, wenn diese auch tatsächlich ausgefallen ist. Dies kann zwar die mit einem zu frühen Austausch verbundenen (unnötigen) Kosten verringern, jedoch kann demgegenüber ein unerwarteter Stillstand des elektrischen Systems erfolgen und dadurch z.B. eine Produktionslinie in unerwarteter Weise stilllegen. Je nach dadurch aufgetretenem Defekt kann dies zu unerwartet hohen Kosten führen.

Die Auswahl, der für die betreffende Anlage und Applikation optimierten Wartungsintervalle kann zu einer globalen Kostenreduktion und zu einer Minimierung der Stillstandzeit des elektrischen Systems führen.

Durch den Einsatz sog. Condition Monitoring Verfahren kann der Zeitpunkt, wann eine Wartung des elektrischen Systems durchgeführt werden soll, optimiert werden, indem die verbliebene Lebenszeit der elektrischen Komponenten bzw. ein Fortschritt eines aktuellen Degradationsprozesses ermittelt wird.

Condition Monitoring kann dabei in drei unterschiedliche Klassen von Ansätzen unterteilt werden.

Im Rahmen der sensorbasierten Condition Monitoring Systeme kann zusätzliche/dedizierte Sensorik und/oder komplexe Messschaltungen verwendet werden, um direkt Größen eines elektrischen Systems zu messen, welche Rückschlüsse auf einen aktuellen Degradationsfortschritt elektrischer Komponenten ermöglichen. Die Komplexität und auch die Implementierungskosten eines derartigen Systems können dabei deutlich steigen. Unterschieden werden kann weiter zwischen Messsystemen, die online im Betrieb eines Stromrichtersystems eingesetzt werden und externer Prüftechnik, die lediglich in festgelegten (vorbestimmten) Intervallen zur Messung verwendet wird.

Im Rahmen modellbasierter Condition Monitoring Systeme wird versucht, einige der vorstehend genannten Probleme zumindest teilweise durch Modellbildung zu überwinden. In diesen Modellen wird der Alterungsvorgang physikalisch oder stochastisch implementiert. Das Modell wird anschließend online im Betrieb mit Lastprofilen und Umgebungsbedingungen als Eingangsvariablen betrieben. Das Ergebnis kann eine stochastische Bewertung der verbliebenen Lebenszeit bzw. des aktuellen Schweregrads der Schädigung sein. Trotz des Wegfalls zusätzlicher Messschaltungen besteht die Herausforderung dennoch in einem Modellaufbau mit ausreichender Güte.

Datenbasierte Condition Monitoring Systeme können derart eingerichtet sein, aus bestehenden Mess- und Zustandsgrößen Muster, die Rückschlüsse auf die Änderung eines Degradationsindikators ermöglichen und damit Rückschlüsse auf eine eingetretene Alterung ermöglichen. Hierbei kann der Informationsgehalt von verschiedenen möglichen Messsignalen und Zustandsgrößen analysiert werden sowie auf Möglichkeiten der Signalverarbeitung zurückgegriffen werden. Dies kann basierend auf statistischen Methoden erfolgen oder basierend auf Methoden der künstlichen Intelligenz.

Bekannte Condiiton Monitoring Verfahren ermöglichen jedoch noch nicht unter allen Umständen eine zufriedenstellende Bestimmung eines Degradationsfortschritts, da diese zu komplexe Hardware, eine zu komplexe Modellbildung oder eine aufwendige Datenanalyse erfordern. In einigen Fällen, sind derzeit verwendete Condition Monitoring Verfahren für den Feldeinsatz schlicht zu ungenau.

Es kann möglich sein, das Condition Monitoring eines Stromrichters, z.B. bei Vorliegen eines (elektrischen) Antriebs auf das Erfassen von mechanischen Vibrationen und/oder elektrischer Signale welche mit dem Betrieb des Antriebs assoziiert sind, zu basieren. Eine Möglichkeit in diesem Zusammenhang kann der Rückgriff auf eine motor current signature analysis (MCSA) sein, welche z.B. angewendet wird, um mechanische Fehler eines Antriebs zu identifizieren, wie z.B. eine Fehlausrichtung, Ungleichgewicht, lockere Füße des Motors, Kavitationseffekte (z.B. bei Pumpen) etc.

Es besteht daher ein Bedarf ein verbessertes Condition Monitoring Verfahren bereitzustellen, welches die Nachteile und Einschränkungen derzeit verwendeter Condition Monitoring Verfahren zumindest teilweise überwindet.

Die vorliegende Erfindung stellt sich daher die technsiche Aufgabe ein verbessertes Condition Monitoring Verfahren bereitzustellen.

Dies wird erreicht durch einen ersten Aspekt der Erfindung, welcher sich auf ein Computer-implementiertes Verfahren zum Bestimmen eines Degradationsfortschritts eines Stromrichters bezieht. Das Computer-implementierte Verfahren umfasst ein Erfassen eines zeitlichen Verlaufs eines Ausgangsstroms und/oder einer Ausgangsspannung des Stromrichters, wobei der Ausgangsstrom und/oder die Ausgangsspannung zur Zuführung zu einem elektrischen Antriebsmittel bestimmt ist sowie ein Bestimmen zumindest eines für den Degradationsfortschritt indikativen Parameters basierend auf dem erfassten zeitlichen Verlauf. Ferner umfasst das Computer-implementierte Verfahren ein Vergleichen des zumindest einen Parameters mit einem vorbestimmten, für den Degradationsfortschritt indikativen Parameters sowie ein Bestimmen des Degradationsfortschritts zumindest teilweise basierend auf dem Vergleichen.

Unter einem Degradationsfortschritt kann vorliegend ein Voranschreiten eines Alterungsprozesses des Stromrichters (hierin auch als Umrichter bezeichnet) verstanden werden. Ein Voranschreiten der Degradation kann mit einer ansteigenden Ausfallwahrscheinlichkeit des Umrichters (z.B. durch einen Defekt) assoziiert sein.

Unter einem zeitlichen Verlauf kann eine temporale Sequenz mehrerer nachfolgend zueinander erfasster Messwerte des Ausgangsstroms und/oder der Ausgangsspannung verstanden werden. In einigen Beispielen kann der zeitliche Verlauf z.B. 1-10 Sekunden, bevorzugter 2-7 Sekunden und am meisten bevorzugt 3-5 Sekunden umfassen. In einigen Beispielen kann der zeitliche Verlauf z.B. eine Zeitspanne von 1-5 Minuten, bevorzugter von 2-4 Minuten umfassen. In einigen Beispielen kann sich der zeitliche Verlauf auch zumindest auf eine Stunde und/oder zumindest einen Tag erstrecken.

Der zeitliche Verlauf kann zu vorbestimmten (diskreten) Zeitpunkten erfasst werden und/oder kann kontinuierlich während des Betriebs des Umrichters erfasst werden.

Das Vergleichen des zumindest einen bestimmten Parameters mit dem vorbestimmten, für den Degradationsfortschritt indikativen Parameters kann ein Vergleichen dahingehend umfassen, ob der vorbestimmte, für den Degradationsfortschritt indikative Parameter größer, kleiner oder gleich des bestimmten zumindest einen Parameters ist. In einigen Fällen kann der vorbestimmte, für den Degradationsfortschritt indikative Parameter einen Schwellenwert repräsentieren, bei dessen Überschreiten/Unterschreiten durch den bestimmten zumindest einen Parameter auf einen notwendigen Austausch des Umrichters (oder dessen Komponenten) geschlossen werden kann.

Auf diese Weise kann eine effiziente Überwachung des Degradationsfortschritts (z.B. im Rahmen eines datenbasierten Condition Monitorings) des Umrichters ermöglicht werden, da auf während des Betriebs eines Stromrichters gesammelte Daten zurückgegriffen werden kann um eine Degradationsfortschritt zu bestimmen. Insbesondere kann durch das Erfassen des Ausgangsstroms und/oder der Ausgangsspannung eine Überwachung des Degradationsfortschritts basierend auf Prozessparametern des Betriebs des Umrichters ermöglicht werden, welche leicht zugänglich sind und beim Betrieb des Stromrichters ohnehin erzeugt werden (z.B. zu Regelungszwecken innerhalb des Stromrichters). Auf diese Weise kann eine Systemkomplexität verringert werden, da keine spezifischen Überwachungssignale vorgesehen werden müssen, basierend auf welchen auf einen Degradationsfortschritt geschlossen werden kann. Insbesondere kann auf zusätzliche Messsensorik, welche zum Zweck des Überwachens des Degradationsfortschritts eingesetzt werden kann, verzichtet werden, da lediglich Messsensorik und/oder Messgrößen für das Computer-implementierte Verfahren erforderlich sind, welche bereits im Umrichter selbst oder in dem System, in welchem der Umrichter verwendet wird, vorhanden sind. Dies kann weiter zu einer Komplexitätsreduktion des Systems beitrage und ein vereinfachtes, kostengünstiges Überwachen des Degradationsfortschritts ermöglichen.

Gemäß einer ersten Ausführungsform kann der Degradationsfortschritt für ein elektrisches Bauteil des Umrichters bestimmt werden, wobei das elektrische Bauteil ein Bipolartransistor mit isolierter Gate-Elektrode, IGBT, ein Zwischenkreiskondensator und/oder ein Sensor ist.

Unter einem Zwischenkreiskondensator kann im vorliegenden Fall ein Kondensator verstanden werden, welcher im Zwischenkreis von Umrichtern angeordnet ist. Der Zwischenkreiskondensator kann die energetische Verkopplung mehrerer elektrischer Netze miteinander auf einer gemeinsamen Gleichspannungsebene bewirken. Ein Zwischenkreis kann zwischen einem Eingangsstromrichter und einem Ausgangsstromrichter angeordnet sein.

Ein Sensor kann z.B. ein Vibrationssensor, ein Temperatursensor, eine Messsensorik zum Messen eines Stroms und/oder einer Spannung oder ein anderer geeigneter Sensor.

Auf diese Weise kann ein datenbasiertes Condition-Monitoring bereitgestellt werden, welches ein effizientes Bestimmen eines Degradationsfortschritts ermöglicht, ohne auf dediziert dazu vorgesehene Messsensorik zurückgreifen zu müssen, da auf diese Weise lediglich auf Betriebsparameter des IGBT, des Zwischenkreiskondensators und/oder des Sensors zurückgegriffen werden muss, welche bereits im Betrieb des Umwandlers generiert werden.

Gemäß einer weitere Ausführungsform kann das Bestimmen des für den Degradationsfortschritts indikativen Parameters ferner ein Ausführen einer Frequenz- und/oder Zeit-Frequenzanalyse umfassen basierend auf dem erfassten zeitlichen Verlauf. Ferner kann das Bestimmen ein Bestimmen des zumindest einen für den Degradationsfortschritt indikativen Parameters aus der ausgeführten Frequenz- und/oder Zeit-Frequenzanalyse umfassen.

Unter einer Frequenzanalyse kann eine Fast Fourier Transform- (FFT-) Analyse verstanden werden, d.h. ein Auftragen der Amplitude verschiedener im erfassten zeitlichen Verlauf enthaltener Frequenzbestandteile gegen die Frequenz.

Unter einer Zeit-Frequenzanalyse kann die Analyse einer im erfassten zeitlichen Verlauf enthaltenen zumindest temporären Wellenform verstanden werden.

In einigen Beispielen kann der erfasste zeitliche Verlauf einem Filter zugeführt werden bevor basierend auf dem erfassten zeitlichen Verlauf die Frequenz- und/oder Zeit-Frequenzanalyse ausgeführt wird.

Auf diese Weise kann ein effizientes Bestimmen des Degradationsfortschritts, welcher sich insbesondere in einer Veränderung einer Frequenzkomponente des erfassten zeitlichen Verlaufs widerspiegelt, ermöglicht werden, wobei lediglich auf mathematische Datenanalyseverfahren zurückgegriffen werden muss, welche effizient implementiert und effizient ausgeführt werden können.

Gemäß einer weiteren Ausführungsform kann der zumindest eine aus der Frequenz- und/oder Zeit-Frequenzanalyse bestimmte Parameter eine Frequenzkomponente und/oder eine Amplitude einer Frequenzkomponente umfassen, welche mit dem erfassten zeitlichen Verlauf assoziiert ist.

Eine Frequenzkomponente kann als in einem FFT-Spektrum bei einer bestimmten Frequenz auftretender Peak verstanden werden.

Auf diese Weise kann eine gezielte Überwachung der im zeitlichen Verlauf auftretenden Frequenzkomponenten ermöglicht werden. Dies bedeutet insbesondere, dass im Zeitverlauf (z.B. bei zwei hintereinander erfassten zeitlichen Verläufen) zusätzlich (graduell oder plötzlich) auftretende oder verschwindende Frequenzkomponenten als Indikator für ein Voranschreiten der zu überwachenden Degradation verstanden werden kann.

Gemäß einer weiteren Ausführungsform kann das Bestimmen des für den Degradationsfortschritts indikativen Parameters ferner umfassen: Analysieren des erfassten zeitlichen Verlaufs in einer Zeitdomäne, bevorzugt durch Fitten einer vorbestimmten Theoriefunktion an den erfassten zeitlichen Verlauf sowie Bestimmen des zumindest einen für den Degradationsfortschritt indikativen Parameters basierend auf dem analysierten zeitlichen Verlauf.

Die Theoriefunktion kann z.B. eine trigonometrische Funktion sein, wie z.B. ein Sinus, Cosiuns, Tangens, Cotangens oder deren respektive Umkehrfunktionen. Zusätzlich oder alternativ kann die Theoriefunktion eine polynominelle Komponente umfassen (wie z.B. ein Polynom ersten Grades (eine Gerade, welche z.B. zum ermitteln einer Steigung des erfassten zeitlichen Verlaufs assoziiert verwendet werden kann) oder hingegen ein Polynom eines höheren grades (z.B. zweiten Grades, dritten Grades, vierten Grades oder eines höheren Grades).

Durch Fitten einer vorbestimmten Theoriefunktion an den erfassten zeitlichen Verlauf kann es ermöglicht werden, eine Veränderung bereits in der Zeitdomäne sichtbare Veränderungen im erfassten zeitlichen Verlauf zu analysieren und so in effizienter Weise auf ein Voranschreiten des Degradationsprozesses schließen zu können.

Gemäß einer weiteren Ausführungsform kann das Vergleichen des zumindest einen Parameters und das Bestimmen des Degradationsfortschritts durch ein trainiertes neuronales Netz ausgeführt werden.

Das neuronale Netz kann als ein Feedforward-Netz ausgestaltet sein. In einigen Fällen kann das trainierte neuronale Netz durch ein Reinforcement-basiertes Lernverfahren trainiert worden sein.

Ein Training des neuronalen Netzes kann z.B. während einer Lebenszyklusphase des Stromrichters erfolgen, während welcher der Stromrichter als "gesund" anzusehen ist, d.h. während einer Lebenszyklusphase, während welcher der Stromrichter noch keiner nennenswerten Degradation unterliegt. In anderen Worten kann das neuronale Netz so auf einen "gesunden" Stromrichter trainiert werden und damit ein Verhalten bzw. eine Charakteristik des "gesunden" Stromrichters abbilden und vorhersagen. Jegliche Diskrepanz hiervon kann hingegen als ein Abweichen vom "gesunden" Zustand des Stromrichters gewertet werden und damit als ein Degradationsfortschritt des Stromrichters interpretiert werden. Insbesondere kann es in diesem Zusammenhang möglich sein, während einer Implementierungsphase des Stromrichters diesen initial zu Charakterisieren und davon eine Abweichung als Schwellenwert abzuleiten, bei dessen Überschreiten auf eine Degradation des Stromrichters geschlossen werden kann und somit als Indikator dafür genutzt werden kann, dass ein Austausch des Stromrichters erfolgen sollte.

Durch das Ausführen des Vergleichens und des Bestimmens durch ein trainiertes neuronales Netz kann die Bestimmung des Degradationsfortschritts weitestgehend automatisiert werden und eine hohe Verlässlichkeit der Bestimmung des Degradationsfortschritts erreicht werden. Es sei angemerkt, dass zusätzlich oder alternativ zu einem neuronalen Netz auch Schwellenwerte definiert werden können, bei deren Überschreiten (z.B. bei einer aus einer Frequenzanalyse gewonnenen Amplitude für eine bestimmte Frequenzkomponente) auf einen Degradationsfortschritt geschlossen werden kann.

Gemäß einer weiteren Ausführungsform kann die Zeit-Frequenz-Analyse eine Wavelet-Transformation umfassen.

Die Wavelet-Transformation kann eine diskrete Wavelet-Transformation umfassen. Alternativ kann die Wavelet-Transformation auch eine kontinuierliche Wavelet-Transformation umfassen.

Durch die Verwendung einer Wavelet-Transformation kann insbesondere die Aussagekraft einer FFT-Analyse für kurze Zeitskalen, d.h. für erfasste kurze zeitliche Verläufe des Ausgangsstroms und/oder der Ausgangsspannung erreicht werden.

Gemäß einer weiteren Ausführungsform kann das Erfassen des zeitlichen Verlaufs ein Überabtasten des Ausgangsstroms und/oder der Ausgangsspannung umfassen.

Unter einem Überabtasten kann ein Abtasten des erfassten zeitlichen Verlaufs mit einer Abtastrate verstanden werden, welche das Nyquist-Kriterium übersteigt. Dies kann bedeuten, dass die Abtastrate mehr als der doppelten Frequenz des abzutastenden Signals entspricht. In einigen Beispielen kann sich die mit dem abzutastenden Signal assoziierte Frequenz auf eine Taktfrequenz des Stromrichters beziehen.

Mit Hilfe der Überabtastung kann es ermöglicht werden, Messwerte mit Schaltzuständen des Stromrichters zu korrelieren. Innerhalb der verwendeten Schaltzustände können Filter und/oder Mittelwertfilter angewandt werden und z.B. zur Schätzung einer Steigung eines zu charakterisierenden Signals verwendet werden.

In einigen Beispielen kann sich an das Überabtasten ein Anwenden einer FFT auf das überabgetastete Signal anschließen. Eine Analyse des so erhaltenen FFT-Spektrums kann eine Analyse von Seitenbändern im FFT-Spektrum umfassen.

Für die Überabtastung können z.B. Phasenströme, Phasenspannungen und/oder eine Zwischenkreisspannung herangezogen werden.

In einigen Fällen kann eine Zwischenkreisspannung z.B. auf einer Eingangsseite des Stromrichters gemessen werden. In einigen Fällen ist es möglich, an einer bestimmten Lokalität einen zentralen Stromrichter bereitzustellen, welcher eine Zwischenkreisspannung für mehrere (Motor-) Stromrichter zur Verfügung stellt. Mögliche Beispiele hierfür können z.B. Fertigungsstraßen und/oder Roboterarme sein, welche mit einer Vielzahl von einzelnen (Motor-) Stromrichtern bereitgestellt sind, aber auch verteilte Gleichspannungsanlagen, wie z.B. die Kopplung von Photovoltaik-Systemen, etc.

Dies kann ermöglichen, auch Frequenzkomponenten zu analysieren, welche eine klassischerweise mit dem Ausgangsstrom und/oder der Ausgangsspannung assoziierten Frequenz übersteigen, jedoch dennoch indikativ für ein Voranschreiten des Degradationsprozesses sein können. Auf diese Weise kann eine Aussagekraft der Analyse des Degradationsfortschritts in effizienter Weise weiter verbessert werden.

Gemäß einer weiteren Ausführungsform kann das Überabtasten mit einer Abtastrate erfolgen, welche zumindest eine, bevorzugter zumindest zwei und am meisten bevorzugt zumindest drei Größenordnungen oberhalb einer Taktfrequenz des Umrichters liegt.

In einigen Fällen kann eine Taktrate des Umrichters z.B. 2 kHz betragen. In einem derartigen Fall müsste für ein Abtasten der Taktrate nach dem Nyquist-Theorem eine Abtastrate gewählt werden, welche zumindest 4 kHz beträgt. Wird die Abtastrate hingegen eine Größenordnung größer gewählt als die Taktrate des Umrichters, so müsste die Taktrate zumindest 20 kHz betragen. Bei zwei Größenordnungen entsprechend 200 kHz und bei drei Größenordnungen zumindest 2 MHz.

Durch die Überabtastung können insbesondere mit fortschreitender Degradation veränderliche Steigungen des erfassten zeitlichen Verlaufs charakterisiert werden. Durch eine Kaskadierung mehrerer Steigungsschätzer kann die Bildung höherer Ableitungen ermöglicht werden (z.B. einer zweiten Ableitung des erfassten zeitlichen Verlaufs mit deren Hilfe auf eine Steigung (bzw. eine zeitliche Änderung) der ersten Ableitung geschlossen werden kann.

Dies kann die Bandbreite des Erfassens möglicher für einen Degradationsfortschritt indikativer Frequenzen weiter erweitern und damit eine zuverlässigere Analyse eines Degradationsfortschritts in effizienter Weise unterstützen. Insbesondere kann eine Überabtastung das datenbasierte Condition Monitoring ferner auf die Zeitbasis von Schaltzuständen erweitern. Häufig ist Regelungssystemen eines Stromrichters bereits eine Überabtastung vorgesehen, wobei die überabgetasteten Werte jedoch einer Mittelwertfilterung unterliegen (z.B. über die Taktperiode des Stromrichters hinweg). Erfindungsgemäß ist es hingegen mit geringem Aufwand möglich, die bereits vorhandene Infrastruktur zu benutzen und basierend darauf, softwarebasiert eine Analyse des überabgetasteten Signals (z.B. zur Steigungsschätzung) vorzunehmen. Eine erfindungsgemäße Implementierung der Überabtastung kann daher kosteneffizient vorgenommen werden.

Ferner kann durch eine Fusion der überabgetasteten Größen mit Mess- und Regelgrößen. Die auf der Zeitbasis der Taktfrequenz ausgewertet werden, eine Separation von Alterungseffekten der Last und des Stromrichters durchgeführt werden. Bereits vorhandene Verfahren, welche nur auf die Auswertung der Regelgrößen gestützt werden, können so effektiv weiter unterstützt und verbessert werden.

Gemäß einer weiteren Ausführungsform kann der Stromrichter eine Vektorsteuerung umfassen, wobei der erfasste zeitliche Verlauf eines Ausgangsstroms und/oder der Ausgangsspannung ein zeitlicher Verlauf eines Drehmoment- oder Feld-erzeugenden Stroms und/oder Spannung ist.

Unter einer Vektorregelung, auch (Feldorientierte Regelung) wird in diesem Zusammenhang ein Regelungskonzept verstanden, bei dem sinusförmige - oder als weitgehend sinusförmig angenommene - Wechselgrößen (beispielsweise Wechselspannungen und Wechselströme) nicht direkt in ihrem zeitlichen Momentanwert, sondern in einem um den Phasenwinkel innerhalb der Periode bereinigten Momentanwert geregelt werden. Zu diesem Zweck können die erfassten Wechselgrößen jeweils in ein mit der Frequenz der Wechselgrößen rotierendes Koordinatensystem übertragen werden. Innerhalb des rotierenden Koordinatensystems ergeben sich dann aus den Wechselgrößen Gleichgrößen, auf die alle üblichen Verfahren der Regelungstechnik angewandt werden können.

In einigen Fällen kann auch eine (geschätzte) Geschwindigkeit und Drehmoment eines existierenden Observermodells herangezogen werden, um auf einen Degradationsfortschritt schließen zu können (z.B. durch Analysieren einer Welligkeit (engl.: *ripple*) bei spezifischen Frequenzen, wenn z.B. ein IGBT oder ein Zwischenkreiskondensator einer Degradation unterliegt).

Somit kann auch gezielt im Falle einer verwendeten Vektorsteuerung ein Bestimmen eines Degradationsfortschritts eines Umrichters ermöglicht werden.

Gemäß einer weiteren Ausführungsform kann der für den Degradationsfortschritt indikative zumindest eine Parameter eine Steigung des Ausgangsstroms und/oder der Ausgangsspannung repräsentieren.

In einigen Beispielen kann sich eine Degradation des Umrichters in z.B. einer schaltzustandabhängigen Steigung einer Messgröße auswirken. So kann sich eine Degradation des Zwischenkreiskondensators z.B. darin manifestieren, dass dieser im Laufe des Alterungsprozesses an Kapazität verliert. Dies kann sich auf eine schaltzustandabhängige Steigung der Zwischenkreisspannung niederschlagen. Zusätzlich oder alternativ kann sich eine Änderung der Durchlassspannung eines im Umrichter verwendeten Halbleiters auf die Stromsteigung an den Phasen widerspiegeln. Änderungen der Steigungen im Zeitverlauf können z.B. auf einen Degradationsfortschritt zurückzuführen sein.

Schaltzustandabhängige Steigungen gemessener Größen können je nach Betriebspunkt des Umrichters (Ausgangsstrom, Ausgangsspannung, elektrischer Winkel, Zwischenkreisspannung, Temperaturen, etc.) speichert werden und deren mögliche Veränderung im Zeitverlauf analysiert werden.

Durch Fusion mit Mess- und Regelgrößen, die auf einer Zeitbasis der Taktfrequenz des Umrichters ausgewertet werden, kann eine Separation von Alterungseffekten der Last und des Umrichters durchgeführt werden.

Dies kann insbesondere Verfahren, welche lediglich auf einer Auswertung von Regelgrößen (z.B. des Ausgangsstroms und/oder der Ausgangsspannung des Umrichters) gerichtet sind, effektiv unterstützen und damit verbessern.

Ein zweiter Aspekt der Erfindung bezieht sich auf ein Computerprogrammprodukt, umfassend Befehle, die bei der Ausführung des Programms durch einen Computer diesen veranlassen, das Computer-implementierte Verfahren nach einem der oben genannten Ausführungsformen auszuführen.

Ein Computerprogrammprodukt, wie z.B. ein Computer-programm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen

Ein dritter Aspekt der Erfindung bezieht sich auf eine Computer-implementierte Vorrichtung zum Bestimmen eines Degradationsfortschritts eines Stromrichters. Die Computer-implementierte Vorrichtung kann eine Erfassungseinheit zum Erfassen eines zeitlichen Verlaufs eines Ausgangsstroms und/oder einer Ausgangsspannung des Stromrichters umfassen, wobei der Ausgangsstrom und/oder die Ausgangsspannung zur Zuführung zu einem elektrischen Antriebsmittel bestimmt ist. Ferner kann die Computer-implementierte Vorrichtung eine Bestimmungseinheit zum Bestimmen zumindest eines für den Degradationsfortschritt indikativen Parameters basierend auf dem erfassten zeitlichen Verlauf sowie eine Vergleichseinheit zum Vergleichen des zumindest einen Parameters mit einem vorbestimmten, für den Degradationsprozess indikativen Parameters umfassen. Ferner kann die Computer-implementierte Vorrichtung eine weitere Bestimmungseinheit zum Bestimmen des Degradationsfortschritts zumindest teilweise basierend auf dem Vergleichen umfassen.

Die Bestimmungseinheit sowie die weitere Bestimmungseinheit können als eine Einheit implementiert sein. In einigen beispielhaften Fällen kann die Bestimmungseinheit jedoch auch von der weiteren Bestimmungseinheit verschieden sein.

Die jeweilige Einheit, zum Beispiel Erfassungseinheit oder Vergleichseinheit oder Bestimmungseinheit, etc., kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

In einer ersten Ausführungsform kann die Computer-implementierte Vorrichtung eine Ausführungseinheit zum Ausführen des Computer-implementierten Verfahrens nach einer der oben genannten Ausführungsformen umfassen.

Die Ausführungseinheit kann z.B. als Computer, Prozessor, Field Programmable Gate Array (FPGA) oder eine Kombination davon vorgesehen sein.

Ein vierter Aspekt der Erfindung bezieht sich auf ein System zum Bestimmen eines Degradationsfortschritts eines Umrichters. Das System kann die Computer-implementierte Vorrichtung nach einer oder oben genannten Ausführungsformen umfassen sowie das Computerprogrammprodukt wie oben beschrieben.

Das Computerprogrammprodukt kann in der Computer-implementierten Vorrichtung enthalten sein. In alternativen Beispielen kann das Computerprogramm auch in einer von der Computer-implementierten Vorrichtung entfernt vorgehaltenen Einheit enthalten sein. In letzterem beispielhaft genannten Fall kann die Computer-implementierte Vorrichtung über ein Netzwerk (z.B. ein lokales Netzwerk oder das Internet) oder eine USB-Verbindung auf das Computerprogrammprodukt zugreifen

Die für die vorgeschlagene Vorrichtung beschriebenen Ausführungsformen und Merkmale gelten für das vorgeschlagene Verfahren entsprechend.

Weitere mögliche Implementierungen der Erfindung umfassen auch nicht explizit genannte Kombinationen von zuvor oder im Folgen-den bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Insbesondere sei angemerkt, dass das oben beschriebene Verfahren bzw. die oben beschriebene Vorrichtung, das oben beschriebene Computerprogrammprodukt sowie das System nicht auf Stromrichter beschränkt ist, sondern auch in anderen industriellen Kontexten Anwendung finden kann.
- Fign. 1A bis 1C: zeigen exemplarische Alterungseffekte wie sie an einem Umrichter auftreten können;
- Fig. 2: zeigt ein exemplarisches Systemdiagramm;
- Fign. 3A und 3B: zeigen ein exemplarisches Anwendungsbeispiel der Bestimmung eines Degradationsfortschritts;
- Fign. 4A und 4B: zeigen exemplarische Frequenzanalysen zur Bestimmung eines Degradationsfortschritts; und
- Fign. 5A und 5B: zeigen den exemplarischen Zusammenhang zwischen einer Frequenzanalyse und einer Kühlkörpertemperatur eines Stromrichters.

In den Figuren sind gleiche oder funktionsgleiche Elemente mit denselben Bezugszeichen versehen worden, sofern nichts anderes angegeben ist.

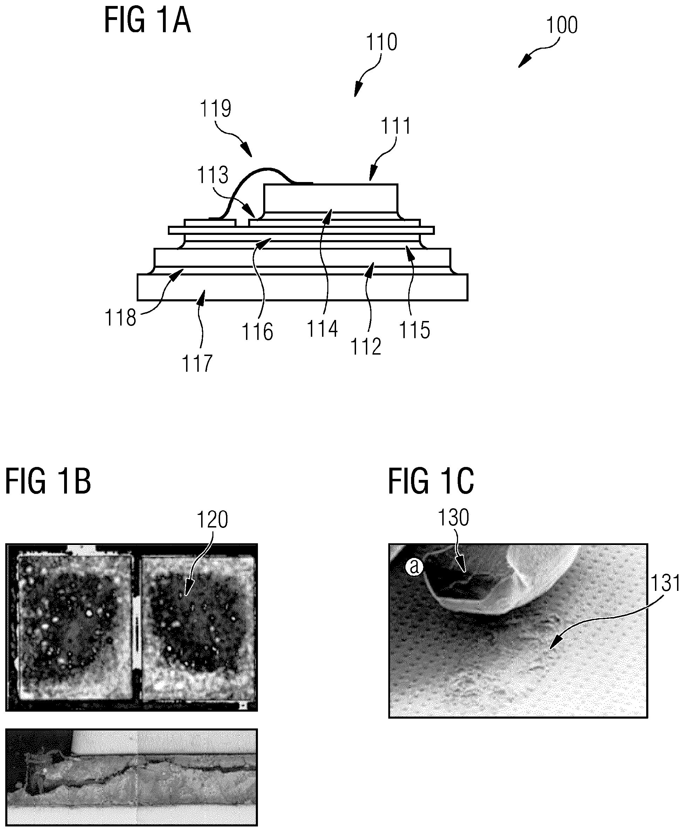

Fign. 1A-1C zeigen exemplarische Degradationseffekte 100 wie sie z.B. an einem (halbleiterbasierten) Umrichter auftreten können.

Fig. 1 zeigt einen exemplarischen Querschnitt durch einen IGBT 110, wie dieser z.B. in einem Umwandler enthalten sein kann.

IGBT besteht aus einem Chip 111, welcher auf einer Basisplatte 112 angeordnet ist. Zwischen dem Chip 111 und der Basisplatte 112 kann eine erste Kupferschicht 113 angeordnet sein, um eine optimale Wärmeleitung zwischen dem Chip 111 und der Basisplatte 112 zu ermöglichen.

Chip 111 kann durch eine erste Lötzinnschicht 114 an der Kupferschicht 113 angebracht sein. Ferner kann die Basisplatte 112 über eine zweite Lötzinnschicht 115 und eine zweite Kupferschicht 116 mit der ersten Kupferschicht 113 verbunden sein.

Basisplatte 112 kann oberhalb einer Kühlplatte 117 angeordnet sein. Zwischen der Basisplatte 112 und der Kühlplatte 117 kann eine Wärmeleitpasteschicht 118 vorgesehen sein.

Ferner kann eine Oberseite des Chips 111 über einen Bonddraht 119 mit einer Stromversorgung (in Fig. 1 nicht abgebildet) verbunden sein.

Fig. 1B zeigt ferner eine mögliche Degradation des Umrichters, welche z.B. durch eine Degradation einer Lötverbindung 120 hervorgerufen werden kann. Derartige Fehler in Lötverbindungen können z.B. durch (thermische) Risse im Lot hervorgerufen werden und/oder durch eine Ablösung der Lötverbindung. Eine Degradation einer Lötverbindung kann zu einer schlechteren elektrischen Kontaktierung führen und damit zu einer schlechteren Übertragung elektrischer Energie zum Betrieb von z.B. einem IGBT 110. Dies kann zu einer Erhöhung des thermischen Widerstands führen und damit zu einer Änderung einer Durchlassspannung des IGBT was zu einer unerwünschten Erwärmung des IGBT führen kann und damit eine Degradation des IGBT 110 weiter vorantreiben kann.

Insbesondere kann eine Degradation der Lötverbindung 120 an der Kontaktierung der Lötzinnschicht 114 mit Chip 111 auftreten (oder an einer Kontaktierung von Lötzinnschicht 115 mit Kupferschicht 116). Eine möglicherweise auftretende Temperaturerhöhung (bzw. Erwärmung) kann nicht nur einen einzelnen Chip 111 betreffen, sondern alle Chips, die auf einem gleichen Direct Bonded Copper-Substrate angebunden sind. In einigen Fällen kann sich das Direct Bonded Copper-Substrate Kupferschicht 113 und Kupferschicht 116 umfassen.

Fig. 1C zeigt eine weitere mögliche Degradation des Umrichters, welche z.B. durch eine Ablösung des Bonddrahtes 130 von einer Stromversorgung 131 hervorgerufen werden kann. In einem derartigen Fall kann z.B. eine Kontaktfläche zwischen dem Bonddraht 130 und der Stromversorgung 131 durch die Ablösung des Bonddrahtes 130 verkleinert werden. Dieser erhöhte Widerstand muss z.B. durch eine Ausgangsstromregelung des IGBT 110 kompensiert werden. Folglich kann der Widerstand dieser Kontaktstelle ansteigen und zu einer Erwärmung des IGBT 110 beitragen und damit dessen Degradation weiter beschleunigen.

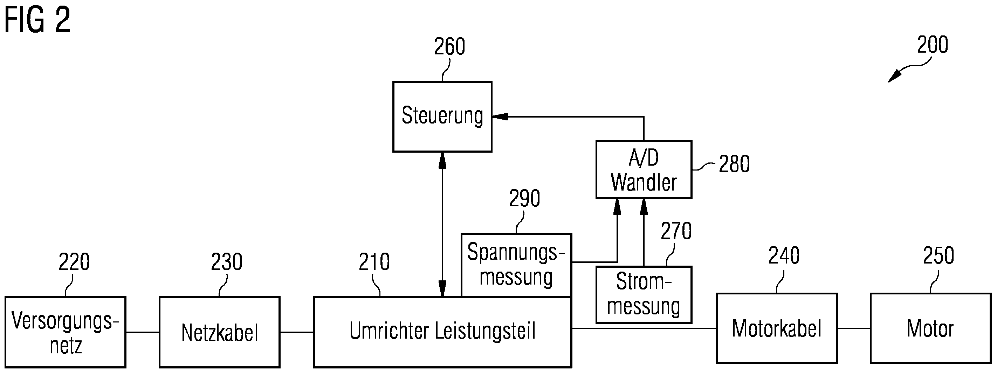

Fig. 2 zeigt ein exemplarisches System 200, welche ein Zusammenwirken eines Stromrichters bzw. Umrichters in einem möglichen erfindungsgemäßen Kontext zeigt.

Unter einem Stromrichter werden vorliegend Vorrichtungen verstanden, welche z.B. Wechselstrom in Gleichstrom umwandeln (Gleichrichter) oder Vorrichtungen, welche einen Gleichstrom in einen Wechselstrom umwandeln (Wechselrichter). Ferner kann unter einem Stromrichter auch ein Umrichter verstanden werden, welcher z.B. als Frequenzumrichter fungieren kann und z.B. eine Änderung einer Wechselstromfrequenz bewirken kann.

Das System 200 umfasst einen Umrichter (Leistungsteil) 210. Der Umrichter 210 wird von einem Versorgungsnetz 220 über ein Netzkabel 230 eingangsseitig mit Strom versorgt.

Ausgangsseitig kann der Umrichter 210 über ein Motorkabel 240 mit einem Motor 250 verbunden sein.

Umrichter 210 kann sich ferner mittels Steuerung 260 in einem geschlossenen Regelkreis befinden, welcher konfiguriert einen Ausgangsstrom des Umrichters 210 konstant zu halten.

Dies kann dadurch erreicht werden, dass ein Ausgangsstrom des Umrichters 210 durch eine Strommessung 270 gemessen wird (z.B. durch Messen eines um ein Kabel (z.B. Motorkabel 240) hervorgerufenen Magnetfelds). Das Resultat der Strommessung 270 kann eine zum Ausgangsstrom proportionale Spannung (z.B. proportionale Ausgangsspannung) sein, welche einem A/D Wandler 280 zugeführt werden kann.

A/D Wandler 280 kann dazu eingerichtet sein, die analoge Ausgangsspannung zu digitalisieren und damit in ein digitales Messsignal umzuwandeln.

Bevorzugt erfüllt die Abtastrate des A/D Wandlers 280 zumindest das Nyquist-Kriterium. In einigen beispielhaften Fällen, wie hierin beschrieben, kann jedoch auch eine Überabtastung des Ausgangsstroms mittels A/D Wandler 280 vorgenommen werden.

In einigen Fällen kann auch eine dedizierte Spannungsmessung 290 (z.B. eine direkte Ausgangsspannung) vorgesehen sein. In einem derartigen, beispielhaften Anwendungsfall kann der A/D Wandler 280 auch direkt die betreffende Ausgangsspannung abtasten.

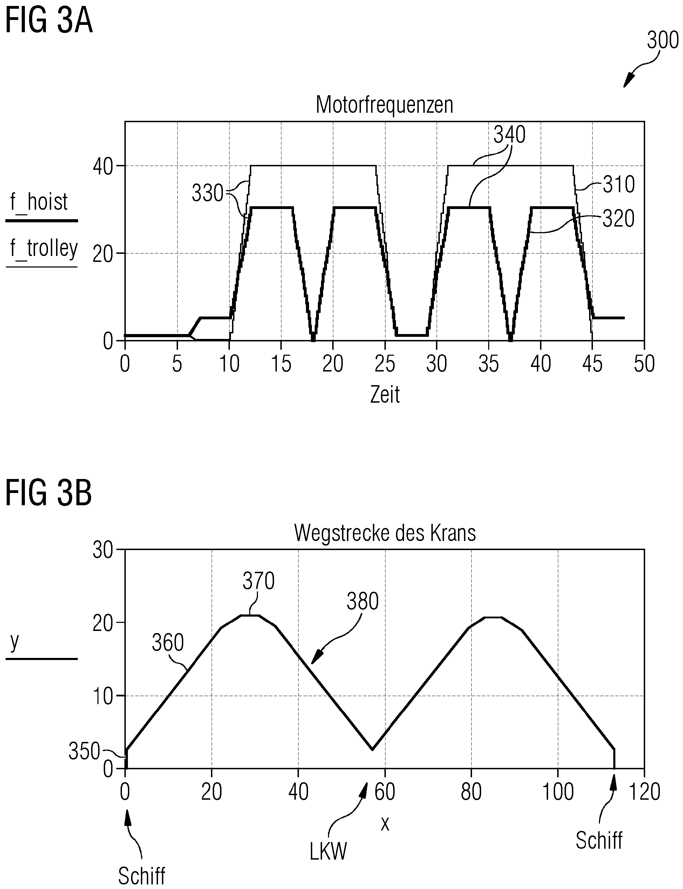

Fign. 3A und 3B zeigen ein exemplarisches Anwendungsbeispiel 300, in welchem ein erfindungsgemäßes Bestimmen eines Degradationsfortschritts erfolgen kann.

Fign. 3A zeigt exemplarisch die Motorfrequenz zweier Kranmotoren *"hoist"* 310 und "*trolley*" 320 aufgetragen gegen eine Zeitskala in z.B. Sekunden. Die exemplarisch dargestellte Abfolge der Motorfrequenzen kann z.B. beim Entladen von Container von einem Schiff auf z.B. einen LKW auftreten kann.

Der exemplarisch dargestellte zeitliche Verlauf der Motorfrequenzen weist dabei Flanken 330 auf, welche indikativ für eine zeitliche Änderung der Motorfrequenz sind. Auf diesen Flanken 330 ändert sich demnach die Motorfrequenz im Zeitverlauf, d.h. der Krankmotor beschleunigt in diesen zeitlichen Intervallen.

Auf Flanken 330 folgen z.B. Bereiche konstanter Motordrehzahl 340, in welchen die Motordrehzahl konstant gehalten wird und sich der Motor mit konstanter Geschwindigkeit bewegt.

Die Bereiche konstanter Motordrehzahl 340 werden als bevorzugt angesehen, um ein Bestimmen eines Degradationsfortschritts durchzuführen, da in diesen Bereichen der Ausgangsstrom des Umrichters (z.B. des Umrichters 210) im Zeitverlauf konstant bleiben sollte (z.B. bei gleichmäßiger Belastung des Kranmotors).

Fig. 3B zeigt exemplarisch die vom Kran zurückgelegte Wegstrecke zwischen dem Schiff, dem LKW und zurück zu dem Schiff.

Die Bewegung des Krans beginnt zunächst mit einer Beschleunigung 350 des Krans bei einer Strecke bzw. Höhe von 0. Dies spiegelt sich in der ansteigenden Flanke 330 der Motordrehzahl wider (Fig. 3A). Bei konstanter Motordrehzahl (Bereich konstanter Motordrehzahl 340) legt der Kran in gleichen Zeitabschnitten eine gleiche Strecke (bzgl. einer Höhe des anzuhebenden Guts) zurück wie durch den Bereich konstanter Geschwindigkeit 360 angezeigt. Auf einen Bereich maximaler Höhe 370 folgend, wird das zu transportierende Gut wieder abgesenkt, was durch eine abfallende Flanke 380 angedeutet ist. Am Ende des Absenkens kann das zu transportierende Gut auf einem LKW abgesetzt werden. Die Höhe ist in diesem Fall erneut 0. Die Bewegungsabfolge kann wiederholt werden, um z.B. ein zu transportierendes Gut von einem LKW zu entnehmen und auf einem Schiff abzusetzen.

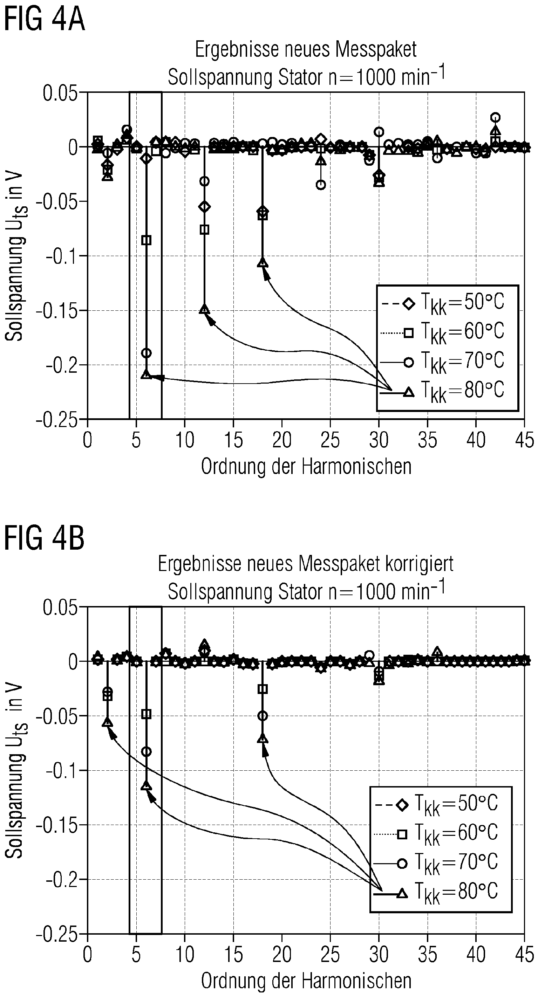

Fign. 4A und 4B zeigen exemplarische Frequenzanalysen zur Bestimmung eines Degradationsfortschritts.

Fign. 4A und 4B zeigen eine an einem Stator anliegende Sollspannung bei 1000 Umdrehungen/Minute für verschiedene Kühlkörpertemperatur eines Umrichters und aufgetragen gegen die Ordnung der jeweiligen aus einer Frequenzanalyse ableitbaren Harmonischen.

Für Fign. 4A und 4B wurde mittels eines Testaufbaus eine Kühlkörpertemperatur (für 50°C, 60°C, 70° und 80°C) nachgebildet, wie sie z.B. bei einer Schädigung des Umrichters (z.B. durch eine Degradation eines Halbleitermaterials des Umrichters) auftreten kann.

Fig. 4A zeigt in diesem Fall einen als funktionsfähig einstufbaren Umrichter während Fig.4B einen Fall zeigt, in welchem der Umrichter einer Degradation unterlag. Hierbei zeigt sich deutlich, dass die Amplitude z.B. der 6. Harmonischem im Falle eines vorliegenden Degradationsfortschritts ca. auf die Hälfte Ihres Werts im funktionsfähigen Fall des Umrichters abgefallen ist (z.B. für eine Kühlkörpertemperatur von 80°C).

Auf diese Weise kann z.B. durch eine Frequenzanalyse, im Spezielleren einer Analyse der dadurch ableitbaren Harmonischen, auf einen Degradationsfortschritt des Umrichters geschlossen werden.

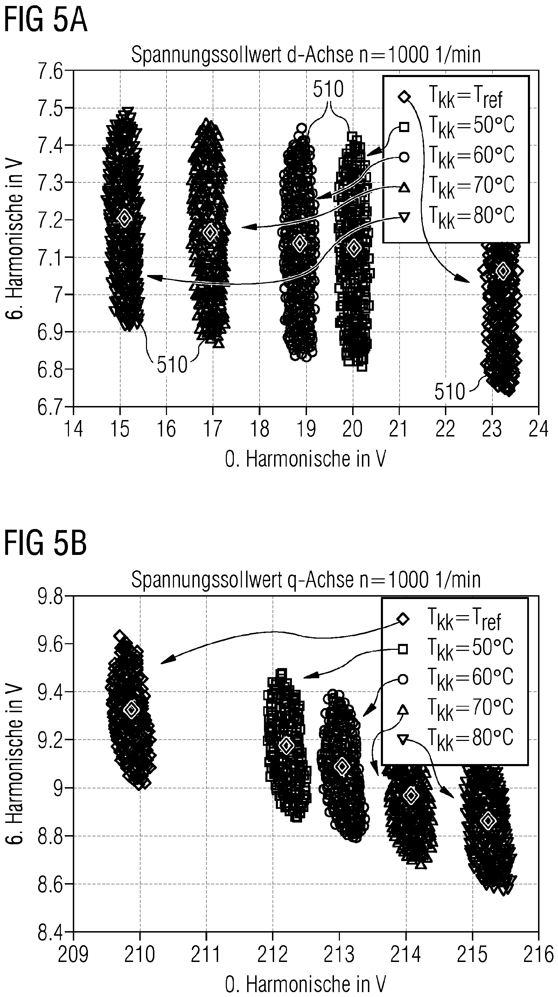

Fign. 5A und 5B zeigen den exemplarischen Zusammenhang zwischen einer Frequenzanalyse und einer Kühlkörpertemperatur eines Stromrichters, wobei der Kühlkörper z.B. von einem IGBT verwendet werden kann und wobei eine Motorfrequenz von 1000 Umdrehungen/Minute angenommen wurde.

In Fign. 5A und 5B wurden mehrere Amplituden der 6. Harmonischen (in V) gegenüber mehreren Amplituden der 0. Harmonischen (in V) für jeweils verschiedene Kühlkörpertemperaturen aufgetragen. Es sei angemerkt, dass die Amplituden der Harmonischen jeweils aus einer Frequenzanalyse, wie hierin beschrieben, gewonnen werden können. Als Folge des Auftragens jeweils mehrerer Amplitudenwerte können sog. Ereigniswolken 510 ausgebildet werden.

Fig. 5A zeigt das zuvor beschriebene Szenario für eine d-Achse einer d/q-Transformation, während Fig. 5B das zuvor beschriebene Szenario für eine q-Achse einer d/q-Transformation zeigt.

Bei einer d/q-Transformation kann das Koordinatensystem mit aufeinander rechtwinkelig stehenden Achsen d und q mit der Kreisfrequenz Ω*ᵣₒₜₒᵣ* mit dem Rotor selbst mitortiert werden. Auf diese Weise kann das Drehfeld bei konstanter Drehzahl in Form zweier zeitlich konstanter Größen d un q beschrieben werden, wobei d die magnetische Flussdichte der magnetischen Erregung des Rotors repräsentieren kann und q ein Ausdruck für das vom Rotor erzeugte Drehmoment sein kann.

Wie aus Fign. 5A und 5B ersichtlich, ergeben sich für verschiedene Temperaturen des betrachteten Kühlkörpers die entsprechenden Ereigniswolken für jeweils unterschiedliche Kombinationen der Amplituden der 6. Harmonischen und 0. Harmonischen. Folglich kann aus den Ereigniswolken auf eine jeweilige Kühlkörpertemperatur geschlossen werden bzw. deren Veränderung durch wiederholtes Ausführen einer Frequenzanalyse, Ableiten der Amplituden der 6. Harmonischen und 0. Harmonischen und Bilden entsprechender Ereigniswolken, im Zeitverlauf überwacht werden.

Es sei darauf hingewiesen, dass das hier diskutierte Beispiel als exemplarisch zu verstehen ist und sich auf einen bestimmten Betriebspunkt des betrachteten Systems bezieht. Bei Betrieb des betrachteten Systems auf einem anderen Betriebspunkt, können sich Abweichungen von den nachfolgend diskutierten Ergebnissen ergeben.

Eine erste Ereigniswolke ergibt sich, gemäß der Darstellung in Fig. 5A (wobei eine Veränderung der Sollspannung der ersten Achse (d-Achse einer dq-Darstellung) aufgetragen ist), für eine Kühlkörpertemperatur von 80°C bei einer Amplitude von ca. 14,7 V -15,5 V der 0. Harmonischen und einem Amplitudenbereich von 6,9 V - 7,5 V der 6. Harmonischen.

Eine zweite Ereigniswolke ergibt sich für eine Kühlkörpertemperatur von 70°C und einem Amplitudenbereich von 18,5 V - 19,5 V der 0. Harmonischen und einem Amplitudenbereich von 6,85 V - 7,45 V der 6. Harmonischen.

Eine dritte Ereigniswolke ergibt sich für eine Kühlkörpertemperatur von 60°C und einem Amplitudenbereich von 16,5 V - 17,5 V der 0. Harmonischen und einem Amplitudenbereich von 6,8 V - 7,443V der 6. Harmonischen.

Eine vierte Ereigniswolke ergibt sich für eine Kühlkörpertemperatur von 50°C und einem Amplitudenbereich von 16,5 V - 17,5 V der 0. Harmonischen und einem Amplitudenbereich von 6,8 V - 7,45 V der 6. Harmonischen.

Eine fünfte Ereigniswolke ergibt sich für eine Referenztemperatur (z.B. von 42°C) der Kühlkörpertemperatur und einem Amplitudenbereich von 22,75 V - 23,5 V der 0. Harmonischen und einem Amplitudenbereich von 6,75 V - 7,45 V der 6. Harmonischen.

Figur 5B zeigt im Vergleich zu Fig. 5A ebenfalls eine Anordnung von fünf Ereigniswolken für die gleichen Kühlkörpertemperaturen welche bereits mit Bezug zu Fig. 5A diskutiert wurden. In Fig. 5B wurde ferner eine Veränderung der Sollspannung der zweiten Achse (q-Achse einer dq-Darstellung) aufgetragen. Allgemein lässt sich feststellen, dass für einige Betriebspunkte eine Betrachtung der Sollspannung der ersten Achse (d-Achse) oder eine Betrachtung der Sollspannung der zweiten Achse (q-Achse) zu einem aussagekräftigen Bestimmen eines Degradationszustands des Stromrichters herangezogen werden kann. In einigen Fällen können die Ergebnisse der ersten Achse und der zweiten Achse auch kombiniert werden, um eine Verbesserung einer Verlässlichkeit abgeleiteter Aussagen zu ermöglichen.

Jedoch treten vorliegend, z.B. in einem Fehlerfall, die jeweiligen Ereigniswolken für anderen Kombination der Amplituden der 0. Harmonischen und der 6. Harmonischen auf.

Eine erste Ereigniswolke ergibt sich vorliegend z.B. für eine Referenztemperatur der Kühlkörpertemperatur und einem Amplitudenbereich von 209,7 V - 210,2 V der 0. Harmonischen und einem Amplitudenbereich von 209,5 V -210,5 V der 6. Harmonischen.

Eine zweite Ereigniswolke ergibt sich vorliegend z.B. für eine Kühlkörpertemperatur von 50°C und einem Amplitudenbereich von 211,9 V - 212, 6 V der 0. Harmonischen und einem Amplitudenbereich von 8,82 V - 9,5 V der 6. Harmonischen.

Eine dritte Ereigniswolke ergibt sich vorliegend z.B. für eine Kühlkörpertemperatur von 60°C und einem Amplitudenbereich von 212,7 V - 213,4 V der 0. Harmonischen und einem Amplitudenbereich von 8,8 V - 9,4 V der 6. Harmonischen.

Eine vierte Ereigniswolke ergibt sich vorliegend z.B. für eine Kühlkörpertemperatur von 70°C und einem Amplitudenbereich von 213,7 V - 214,5 V der 0. Harmonischen und einem Amplitudenbereich von 8,7 V - 9,3 V der 6. Harmonischen.

Eine fünfte Ereigniswolke ergibt sich vorliegend z.B. für eine Kühlkörpertemperatur von 80°C und einem Amplitudenbereich von 214,8 V - 215,6 V der 0. Harmonischen und einem Amplitudenbereich von 8,6 V - 9,2 der 6. Harmonischen.

Auf diese Weise kann eine effiziente Überwachung einer Kühlkörpertemperatur (und damit eines Degradationsfortschritts eines betrachteten Stromrichters) ermöglicht werden, wobei lediglich auf Messgrößen zurückgegriffen werden muss, welche ohnehin bereits im Normalbetrieb des Systems erzeugt bzw. erfasst werden. Es ist somit insbesondere nicht erforderlich, spezifische Messsensorik zum Erfassen einer Kühlkörpertemperatur vorzusehen.

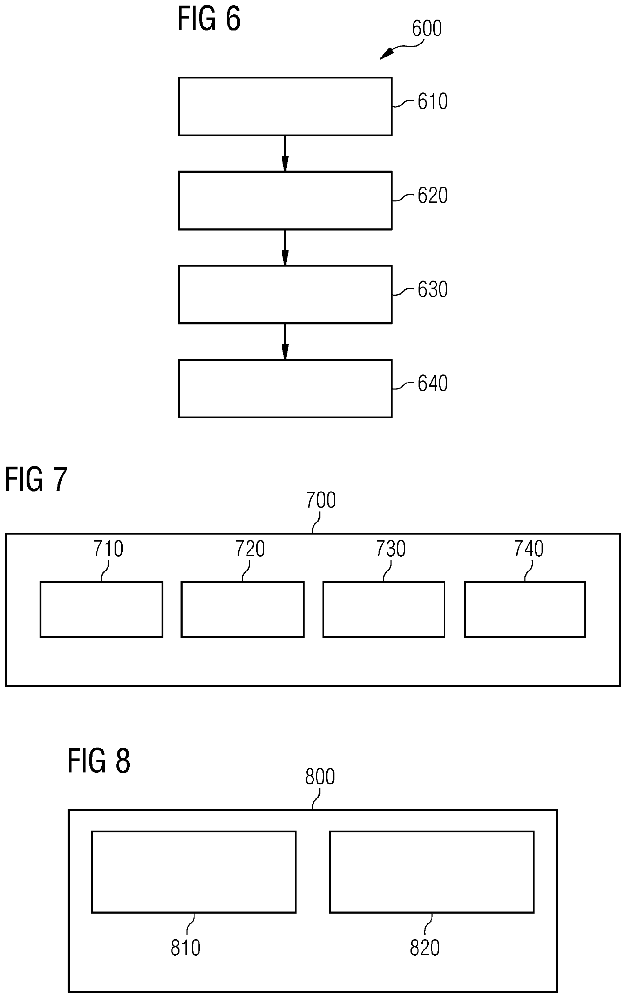

Fig. 6 zeigt ein Ablaufdiagramm eines exemplarischen Computer-implementierten Verfahrens 600 zur Bestimmung eines Degradationsfortschritts eines Stromrichters gemäß einem Aspekt der vorliegenden Erfindung.

In Schritt 610, erfolgt ein Erfassen eines zeitlichen Verlaufs eines Ausgangsstroms und/oder einer Ausgangsspannung des Stromrichters, wobei der Ausgangsstrom und/oder die Ausgangsspannung zur Zuführung zu einem elektrischen Antriebsmittel bestimmt ist.

In Schritt 620 erfolgt ein Bestimmen zumindest eines für den Degradationsfortschritt indikativen Parameters basierend auf dem erfassten zeitlichen Verlauf.

In Schritt 630 erfolgt ein Vergleichen des zumindest einen Parameters mit einem vorbestimmten, für den Degradationsfortschritt indikativen Parameters.

In Schritt 640 erfolgt ein Bestimmen des Degradationsfortschritts zumindest teilweise basierend auf dem Vergleichen.

Fig. 7 zeigt eine exemplarische Computer-implementierte Vorrichtung 700 zum Bestimmen eines Degradationsfortschritts eines Stromrichters gemäß einem Aspekt der vorliegenden Erfindung. Die Vorrichtung 700 beinhaltet eine Erfassungseinheit 710, eine Bestimmungseinheit 720, eine Vergleichseinheit 730 sowie eine weitere Bestimmungseinheit 740.

Erfassungseinheit 710 ist konfiguriert zum Erfassen eines zeitlichen Verlaufs eines Ausgangsstroms und/oder einer Ausgangsspannung des Stromrichters, wobei der Ausgangsstrom und/oder die Ausgangsspannung zur Zuführung zu einem elektrischen Antriebsmittel bestimmt ist.

Bestimmungseinheit 720 ist konfiguriert zum Bestimmen zumindest eines für den Degradationsfortschritt indikativen Parameters basierend auf dem erfassten zeitlichen Verlauf.

Vergleichseinheit 730 ist konfiguriert zum Vergleichen des zumindest einen Parameters mit einem vorbestimmten, für den Degradationsprozess indikativen Parameters.

Weitere Bestimmungseinheit 740 ist konfiguriert zum Bestimmen des Degradationsfortschritts zumindest teilweise basierend auf dem Vergleichen.

Fig. 8 zeigt ein exemplarisches System 800 zum Bestimmen eines Degradationsfortschritts eines Stromrichters gemäß einem Aspekt der vorliegenden Erfindung. Das System 800 beinhaltet Computer-implementierte Vorrichtung 810 und ein Computerprogrammprodukt 820.

Die Computer-implementierte Vorrichtung 810 kann konfiguriert sein wie hierin beschrieben.

Das Computerprogrammprodukt 820 kann konfiguriert sein wie hierin beschrieben.

Unabhängig vom grammatikalischen Geschlecht eines bestimmten Begriffes sind Personen mit männlicher, weiblicher oder anderer Geschlechteridentität mit umfasst.

## Patentansprüche

1. Computer-implementiertes Verfahren (600) zum Bestimmen eines Degradationsfortschritts eines Stromrichters, umfassend:
Erfassen (610) eines zeitlichen Verlaufs eines Ausgangsstroms und/oder einer Ausgangsspannung des Stromrichters, wobei der Ausgangsstrom und/oder die Ausgangsspannung zur Zuführung zu einem elektrischen Antriebsmittel bestimmt ist;
Bestimmen (620) zumindest eines für den Degradationsfortschritt indikativen Parameters basierend auf dem erfassten zeitlichen Verlauf;
Vergleichen (630) des zumindest einen Parameters mit einem vorbestimmten, für den Degradationsfortschritt indikativen Parameters;
Bestimmen (640) des Degradationsfortschritts zumindest teilweise basierend auf dem Vergleichen.

2. Computer-implementiertes Verfahren nach Anspruch 1, wobei der Degradationsfortschritt für ein elektrisches Bauteil des Umrichters bestimmt wird, wobei das elektrische Bauteil ein Bipolartransistor mit isolierter Gate-Elektrode, IGBT, ein Zwischenkreiskondensator und/oder ein Sensor ist.

3. Computer-implementiertes Verfahren nach einem der Ansprüche 1 oder 2, das Bestimmen des für den Degradationsfortschritts indikativen Parameters ferner umfassend:
Ausführen einer Frequenz- und/oder Zeit-Frequenzanalyse basierend auf dem erfassten zeitlichen Verlauf;
Bestimmen des zumindest einen für den Degradationsfortschritt indikativen Parameters aus der ausgeführten Frequenz- und/oder Zeit-Frequenzanalyse.

4. Computer-implementiertes Verfahren nach Anspruch 3, wobei der zumindest eine aus der Frequenz- und/oder Zeit-Frequenzanalyse bestimmte Parameter eine Frequenzkomponente und/oder eine Amplitude einer Frequenzkomponente umfasst, welche mit dem erfassten zeitlichen Verlauf assoziiert ist.

5. Computer-implementiertes Verfahren nach einem der Ansprüche 1-4, das Bestimmen des für den Degradationsfortschritts indikativen Parameters ferner umfassend:
Analysieren des erfassten zeitlichen Verlaufs in einer Zeitdomäne, bevorzugt durch Fitten einer vorbestimmten Theoriefunktion an den erfassten zeitlichen Verlauf;
Bestimmen des zumindest einen für den Degradationsfortschritt indikativen Parameters basierend auf dem analysierten zeitlichen Verlauf.

6. Computer-implementiertes Verfahren nach einem der Ansprüche 1-5, wobei das Vergleichen des zumindest einen Parameters und das Bestimmen des Degradationsfortschritts durch ein trainiertes neuronales Netz ausgeführt wird.

7. Computer-implementiertes Verfahren nach Anspruch 6, wobei die Zeit-Frequenz-Analyse eine Wavelet-Transformation umfasst.

8. Computer-implementiertes Verfahren nach einem der Ansprüche 1-7, wobei das Erfassen des zeitlichen Verlaufs ein Überabtasten des Ausgangsstroms und/oder der Ausgangsspannung umfasst.

9. Computer-implementiertes Verfahren nach Anspruch 8, wobei das Überabtasten mit einer Abtastrate erfolgt, welche zumindest eine, bevorzugter zumindest zwei und am meisten bevorzugt zumindest drei Größenordnungen oberhalb einer Taktfrequenz des Umrichters liegt.

10. Computer-implementiertes Verfahren nach einem der Ansprüche 1-9, wobei der Umrichter eine Vektorsteuerung umfasst und wobei der erfasste zeitliche Verlauf eines Ausgangsstroms und/oder der Ausgangsspannung ein zeitlicher Verlauf eines Drehmoment- oder Feld-erzeugenden Stroms und/oder Spannung ist.

11. Computer-implementiertes Verfahren nach einem der Ansprüche 1-10, wobei der für den Degradationsfortschritt indikative zumindest eine Parameter eine Steigung des Ausgangsstroms und/oder der Ausgangsspannung repräsentiert.

12. Computerprogrammprodukt, umfassend Befehle, die bei der Ausführung des Programms durch einen Computer diesen veranlassen, das Computer-implementierte Verfahren nach einem der Ansprüche 1-11 auszuführen.

13. Computer-implementierte Vorrichtung (700) zum Bestimmen eines Degradationsfortschritts eines Stromrichters, umfassend:
eine Erfassungseinheit (710) zum Erfassen eines zeitlichen Verlaufs eines Ausgangsstroms und/oder einer Ausgangsspannung des Stromrichters, wobei der Ausgangsstrom und/oder die Ausgangsspannung zur Zuführung zu einem elektrischen Antriebsmittel bestimmt ist;
eine Bestimmungseinheit (720) zum Bestimmen zumindest eines für den Degradationsfortschritt indikativen Parameters basierend auf dem erfassten zeitlichen Verlauf;
eine Vergleichseinheit (730) zum Vergleichen des zumindest einen Parameters mit einem vorbestimmten, für den Degradationsprozess indikativen Parameters;
eine weitere Bestimmungseinheit (740) zum Bestimmen des Degradationsfortschritts zumindest teilweise basierend auf dem Vergleichen.

14. Computer-implementierte Vorrichtung, umfassend:
eine Ausführungseinheit zum Ausführen des Computer-implementierten Verfahrens nach einem der Ansprüche 1 bis 11.

15. System (800) zum Bestimmen eines Degradationsfortschritts eines Umrichters, umfassend: die Computer-implementierte Vorrichtung (810) nach einem der Ansprüche 13 oder 14;
das Computerprogrammprodukt (820) nach Anspruch 12.
